# EUROPEAN PATENT APPLICATION

(11) **EP 1 321 968 A2**
(43) Date of publication of application: **25.06.2003**
(21) Application number: 02026827.2
(22) Date of filing: 28.11.2002
(51) Int. Cl.: H01L 21/00

(54) **Suction holding device**

(30) Priority: 04.12.2001 JP 2001370045
(71) Applicant: LINTEC Corporation, Tokyo (JP)
(72) Inventor: Kurokawa, Shuji, Lintec Corporation, Tokyo (JP)
(74) Representative: Grünecker, Kinkeldey, Stockmair & Schwanhäusser Anwaltssozietät

(57) **Abstract**

A suction holding device 10 comprises a table 24 on which a wafer holder **H** is mounted, and suction side conduits 25 connected to the table 24. The table 24 includes a suction plane 28 provided with a plurality of suction holes 27 on its upper side, and a chamber 32 in fluid communication with the suction holes 27. The chamber 32 is arranged such that it is divided into a plurality of cells 37, 38 and 39 each isolated from others, and that, when the wafer holder **H** is removed from the suction plane 28, air is independently supplied to respective cells 37-39, from the outer side of the table 24 toward the inner side in order.

## Description

### BACKGROUND OF THE INVENTION

### Field of the Invention

This invention relates to a suction holding device and, more specifically, to a suction holding device which can prevent an object from bowing deformation when the object is removed from a suction plane.

### Description of the Related Art

Conventionally, a peeling device for automatically peeling a protective sheet laminated on the front side constituting the circuit surface of generally disc shaped semiconductor wafer (hereinafter simply referred to as "wafer") is known. The peeling device is constituted such that a wafer holder including a wafer whose backside is adhered to a dicing tape exposed inside of a ring frame is sucked and held by a suction holding device, the protective sheet is peeled off in the state, and then the wafer holder is sucked to be taken out from the suction holding device side.

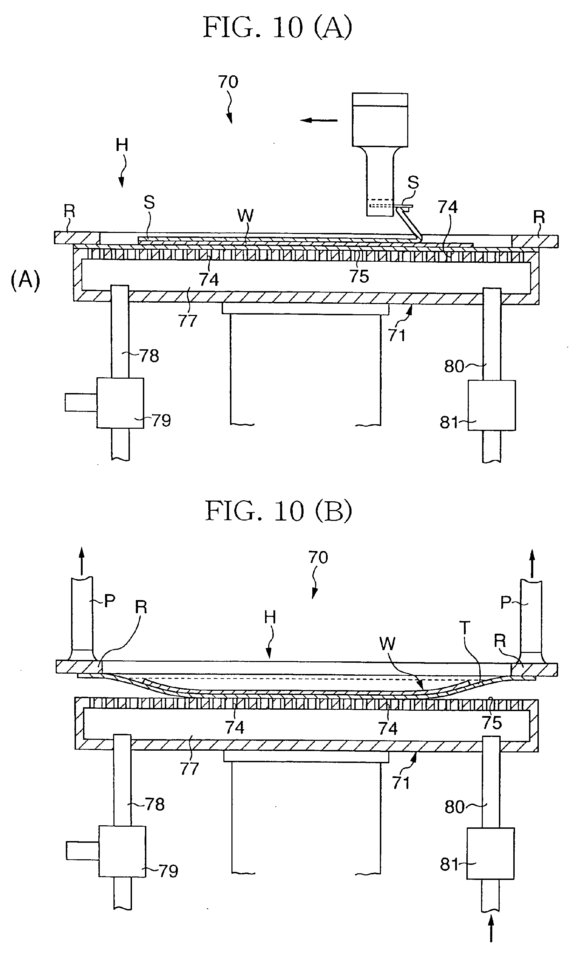

As for the suction holding device, a suction holding device 70 as shown in Fig. 10(A), for example, is known. The suction holding device 70 includes a table 71 on which a wafer holder H for holding a wafer W having a laminated protective sheet S is mounted, a vacuum generator (not shown) connected to the table 71, and an air supplier (not shown) such as an air compressor for supplying air into the table 71. The table 71 has a suction plane 75 on the upper side having a plurality of suction holes 74, a chamber 77 of a single room communicating with the suction holes 74, a suction side conduit 78 connecting inside of the chamber 77 to the vacuum generator, an air supply side conduit 80 connecting the inside of the chamber 77 to the air supplier, and an air supply control valve 81.

As shown in Fig. 10(B), the wafer holder H is removed, after the protective sheet has been peeled from the table 71 by the lift of a suction pad P after the ring frame R portion is sucked to the suction pad P. On this occasion, suction for the chamber 77 is interrupted, and in order to make a break of residual vacuum state in the chamber 77 (hereinafter referred to as "vacuum break"), air is supplied by the air supplier into the chamber 77 so that the air spouts from the suction holes 74.

However, the suction holding device 70 has a drawback that, since the chamber 77 is constituted of a single room, air supplied into the chamber 77 during the vacuum break flows more toward the peripheral side of the wafer holder H where is easy to escape for the air, but hardly flows round the central side thereof. As a result, when the wafer holder H is removed from the table 71, a suction force to the table 71 still remains in area near the center of the wafer holder H; thus, as shown in Fig. 10(B), along with the lift of the suction pad P, an bowing deformation, in which the peripheral side of wafer W curves up to a level higher than the central side thereof, is apt to occur. Especially, thickness of recent wafers W is ultrathin in the order of 100µm - 30µm in comparison with the conventional wafer having thickness in the order of 350µm - 200µm, and such an extremely thin wafer W has a disadvantage that when the bowing deformation occurs cracks or damages are apt to occur on the wafer W.

### SUMMARY OF THE INVENTION

The present invention is proposed in view of the problems. An object of the invention is to provide a suction holding device capable of preventing an object, such as a wafer, from occurrence of cracks caused by a bowing deformation when the object is removed from a suction plane.

In order to achieve the object, the invention provides a suction holding device comprising a chamber in fluid communication with a suction plane, and being capable of sucking and holding a predetermined object on the suction plane, wherein;
the chamber is divided into a plurality of isolated cells and air is independently supplied to respective cells when the object is removed from the suction plane; and
the air supply to the respective cells is initiated from a cell located on the peripheral side of suction plane toward a cell located on the central side thereof in order. With this arrangement, since the chamber is divided into a plurality of cells each isolated from others and, when the object is removed from the suction plane, air is supplied independently to respective cells, the vacuum can be surely broken in the generally whole area in the chamber; thus preventing the object from a bowing deformation when removed from the suction plane. In addition, as air is supplied from a cell located on the peripheral side of the suction plane toward a cell located on the central side of the suction plane in order, a bowing deformation occurring when air is supplied in the adverse order, that is, a dish-shaped bowing deformation with the central part of object floating from the suction plane can be also prevented.

Preferably the chamber according to the invention is arranged to be comparted from the peripheral side of the suction plane toward the central side thereof. With this arrangement, the air supply to a cell on the peripheral side, from which air is easy to escape, and toward a cell on the central side, from which air is difficult to escape, can be independently controlled, resulting in more assured prevention of a bowing deformation of the object.

### BRIEF DESCRIPTION OF THE DRAWINGS

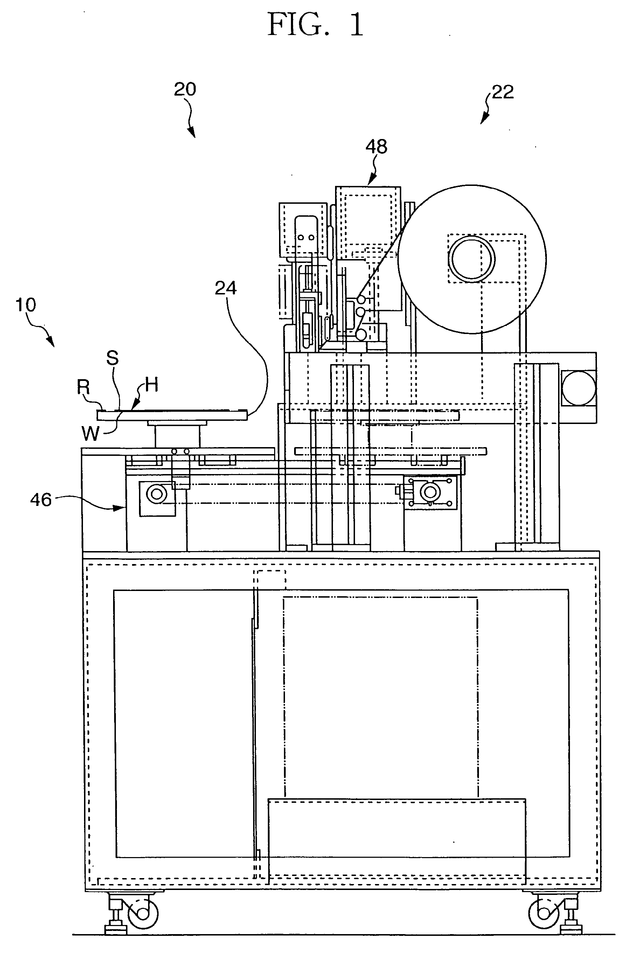

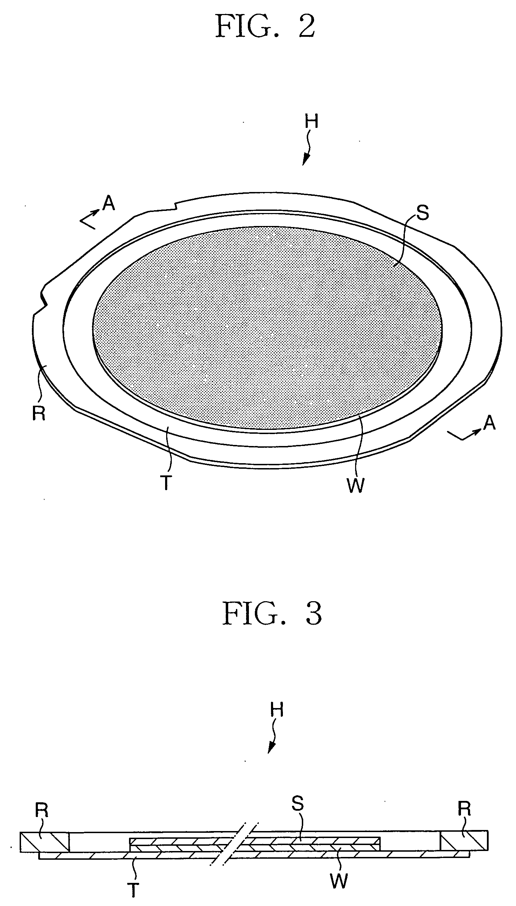

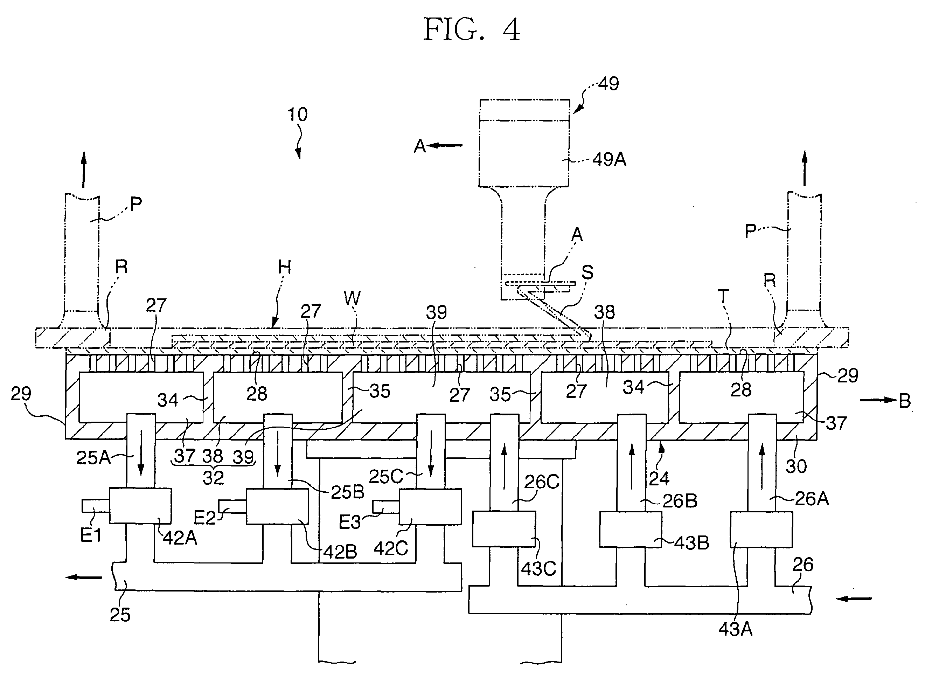

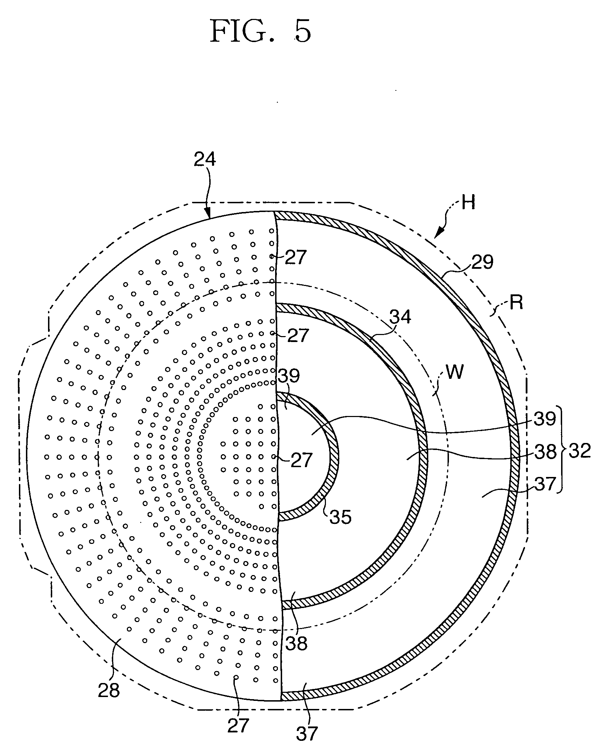

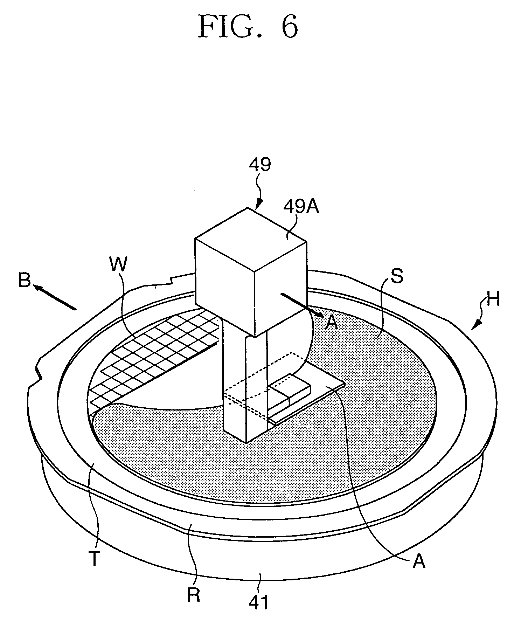

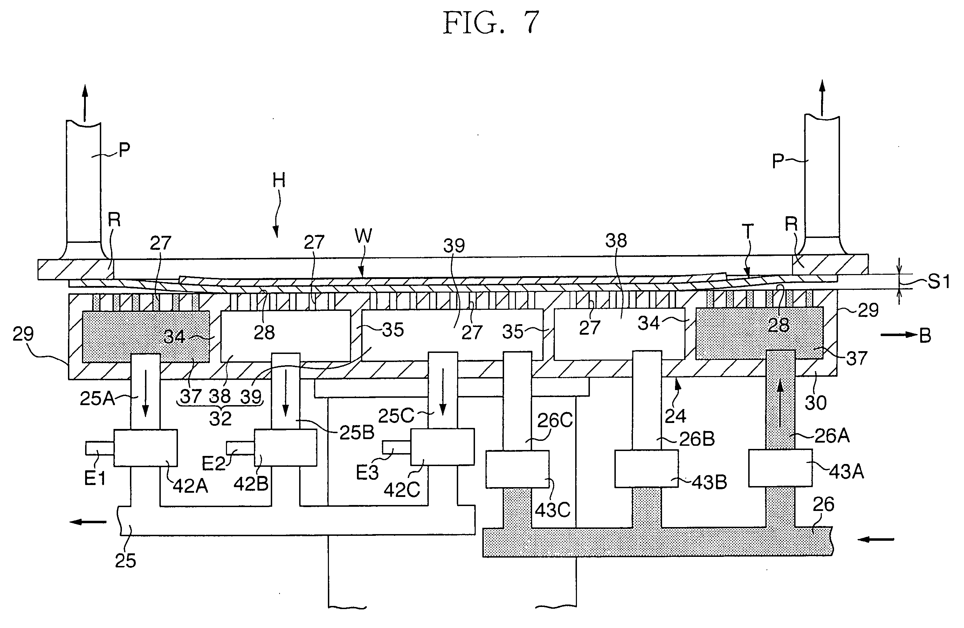

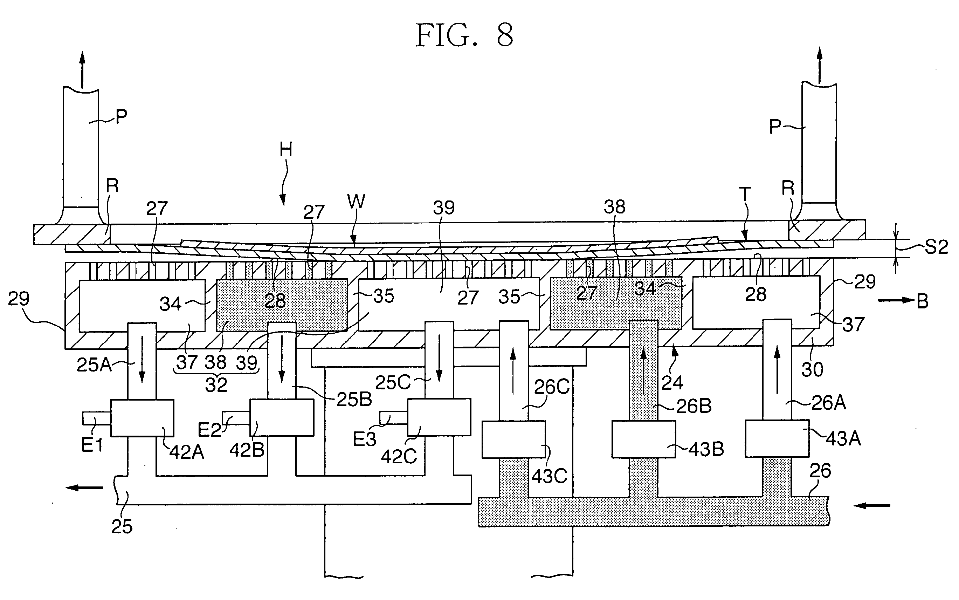

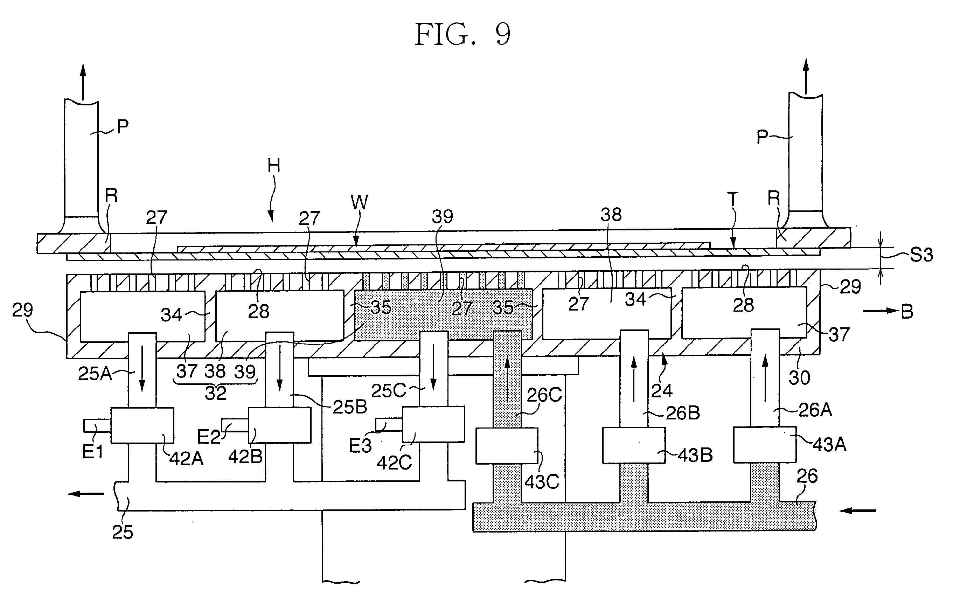

Fig. 1 is a side view showing the whole configuration of a peeling device with a suction holding device according to the present invention; Fig. 2 is a schematic perspective view showing a wafer holder H for being applied to the peeling device; Fig. 3 is an enlarged vertical sectional view of Fig. 2 taken along an arrow line A-A; Fig. 4 is an enlarged sectional view showing principal parts of the suction holding device of the embodiment; Fig. 5 is a half sectional plan view of the suction holding device; Fig. 6 is a schematic perspective view sowing a peeling process by the peeling device; Fig. 7 is an enlarged sectional view showing vacuum break in a first cell when the wafer holder is removed from the suction holding device; Fig. 8 is an enlarged sectional view showing the vacuum break in a second cell after the state in Fig. 7; Fig. 9 is an enlarged sectional view showing the vacuum break in a third cell after the state in Fig. 8; Fig. 10(A) is a sectional view of principal parts of a conventional suction holding device; and Fig. 10(B) is a sectional view of principal parts showing a drawback caused by the suction holding device shown in Fig. 10(A).

### DETAILED DESCRIPTION OF THE PREFERRED EMBODIMENT

The embodiment of the present invention will be described below with reference to the drawings.

In Fig. 1, a schematic side view of a peeling device 20, to which a suction holding device 10 according to the invention is applied, is shown. In Fig. 2, a schematic perspective view of a wafer holder H as an object to be applied to the peeling device 20 is shown. In Fig. 3, an enlarged vertical sectional view of Fig. 2 is shown. In these drawings, the wafer holder H comprises a generally disc shaped wafer W whose front side (upper side) constitutes a circuit surface, a protective sheet S laminated on the circuit surface of the wafer W, a dicing tape T adhered on the back side of the wafer W, and a ring frame R adhered along the peripheral part of the dicing tape T.

The peeling device 20 is a device for automatically peeling the protective sheet S from the wafer W before applying the dicing process. That is, the peeling device 20 comprises a suction holding device 10 for sucking and holding the wafer holder H, and peeling means 22 for peeling the protective sheet S from the wafer W of the wafer holder H sucked and held by the suction holding device 10.

As shown in Figs. 4 and 5, the suction holding device 10 comprises a generally disc shaped table 24 on which the wafer holder H is laid, and a vacuum generating system or apparatus and air supplier such as air compressor, known and not shown, connected to the table 24 respectively.

The table 24 comprises a suction plane 28 provided with a plurality of suction holes 27 located on its upper side, a circumferential side plane 29 joining to the peripheral side of the suction plane 28, the bottom plane 30 located on the lower side of the circumferential side plane 29, and a chamber 32 formed inside of these suction plane 28, circumferential side plane 29 and bottom plane 30 and is in fluid communication with the suction holes 27.

In the chamber 32, annular partition walls 34, 35 extending along the circumferential direction of suction plane 28 are provided, thereby the chamber 32 is divided from the peripheral side of suction plane 28 toward the central side thereof. Thus, the chamber 32 is divided into three cells 37, 38 and 39 each isolated from others. Hereinafter, it is assumed that the cell 37 of generally annular in a plane shape locating on the outer most side is called as a first cell 37, a cell 38 of generally annular in a plane shape locating inside the first cell 37 is called as a second cell 38, and a cell 39 of generally annular in a plane shape locating inside the second cell 38 is called as a third cell 39.

Into the first, second and third cells 37, 38 and 39, suction side conduits 25A, 25B and 25C, each connected to the vacuum generating system or apparatus (not shown), are coupled respectively; and on their way a first, second and third vacuum control valves 42A, 42B and 42C are provided for controlling the rate of air flowing through respective suction conduits 25A, 25B and 25C.

Further, into the first, second and third cells 37, 38 and 39, supply side conduits 26A, 26B and 26C, each connected to the air supplier (not shown), are coupled respectively; and on their way a first, second and third air supply control valves (vacuum breaking valve) 43A, 43B and 43C are provided for controlling the rate of air flowing through respective supply side conduits 26A, 26B and 26C.

With the arrangement, by operating the vacuum generating system or apparatus and the air supplier, independent control of air suction and supply in respective first, second and third cells 37, 38 and 39 can be performed.

That is, when the wafer holder H is sucked and held on the suction plane 28, air is sucked from the inside toward the outside from the third cell 39, second cell 38 and first cell 37 in order by operating the vacuum control valves 42A-42C connected to the vacuum pump system or apparatus, and the cells 37, 38 and 39 are kept in a vacuum state, resulting in generating a suction force in the suction holes 27. Here, since the vacuum state is resulted from the inside toward the outside according to the order of the third, second and first cells 39, 38 and 37, the wafer holder H can be sucked and held on the suction plane 28 with no residual air between the inside area on the suction plane 28 and the dicing tape T of the wafer holder H.

On the other hand, when the wafer holder H is removed from the suction plane 28, the suction of air is stopped, and air is supplied into the first, second and third cells 37, 38 and 39 at timings described later by operating the first, second and third air supply control valve 43A, 43B and 43C, respectively, to allow the air to jet out from the suction holes 27, resulting in breaking the vacuum.

As shown in Fig. 1, the table 24 is provided with a transfer mechanism 46 for transferring the table 24 in a predetermined direction when the protective sheet S is peeled by the peeling means 22. The transfer mechanism 46 includes known structures such as various rail structures, motors, feed screw shafts and cylinders to allow the table 24 to move in a generally horizontal direction. The shape of the table 24 is not limited to the embodiment shown in the drawings, but may be other such as a rectangular.

As schematically shown in Fig. 6, the peeling means 22 is arranged so that it can adhere a peeling tape having adhesion force higher than the tack strength between the protective sheet S and the wafer W to the protective sheet S at one end, and peel off the protective sheet S from the wafer W, by being moved, while folding one end of the peeling tape, in the direction of the other end relative to the wafer W. That is, the peeling means 22 shown in Fig. 1 adopts configurations having been proposed by the present applicant (refer to Japanese Patent Application No 2000-106827 or the like), and comprises a tape adhering and cutting means 48 (refer to Fig. 1) for adhering the peeling tape A to the protective sheet S at one end, and a folding means 49 including a peeling head portion 49A (refer to Figs. 4 and 6) capable of folding the end of the peeling tape A. Since the tape adhering and cutting means 48 and folding means 49 are not substance of the invention, description of them will be omitted here.

Next, operation of the peeling device 20 will be described.

As shown in Fig. 4, the wafer holder H is transferred onto the table 24 after the upper part of its ring frame R is sucked to the plural suction pads P movable by driving of a robot etc. (not shown). Then the suction pads P retracts upwardly away from the wafer holder H, the vacuum generating system or apparatus (not shown) is actuated, and, by switch-over actuation of the vacuum control valves 42A, 42B and 42C connected to the suction side conduits 25A, 25B and 25C, respectively, to bring the first, second and third cells 37, 38 and 39 into a vacuum state, the wafer holder H is sucked and held onto the suction plane 28. From this state, after the peeling tape A is thermally adhered to the peripheral side of the protective sheet S laminated on the wafer W, the peeling tape is folded at its end by the peeling head 49A, and the peeling head 49A is moved in the direction indicated by an arrow A (Fig. 4), while the table 24 is moved in the direction away from the peeling head 49A (direction indicated by an arrow B), to peel off the protective sheet S from the wafer W.

After the sheet S is peeled from the wafer W, respective vacuum control valves 42A, 42B and 42C are switched over so that suction side ports are closed and release side ports E1, E2 and E3 are opened to make insides of the first, second and third cells 37 to 39 be opened to the atmosphere. After that, the suction pad P sucks and holds the upper part of the ring frame R again while keeping respective release side ports E1, E2 and E3 also in closed state. In the state, by switching respective air supply control valves (vacuum breaking valve) 43A, 43B and 43C of the air supply side conduits 26A, 26B and 26C, air is supplied into the cells 37, 38 and 39 through the air supply side conduits 26A, 26B and 26C to perform the vacuum break. On this occasion, supply of compressed air is initiated from the peripheral side to the center, that is, from the first supply side conduit 26A, second conduit 26B and third conduit 26C in order; the suction pad P is lifted in sync with the supply of compressed air to the first, second and third cells 37, 38 and 39 (vacuum break) at predetermined timings (Figs. 7-9); and in connection with this, the wafer holder H having the wafer W after the peeling of the protective sheet S is lifted from the table 24 to predetermined lift heights S1, S2 and S3 in order. That is, as shown in Fig. 7, the vacuum break between the dicing tape T of the wafer holder H over the first cell 37 and the suction surface 28 is performed by supplying the compressed air only into the first cell 37 located in the outermost side with operation of the air supply control valve 43A, then the outer side of the wafer holder H is separated first from the suction plane 28 and lifted to the lift height S1 by the suction pad P. Next, as shown in Fig. 8, the vacuum break between the dicing tape T of the wafer holder H and the suction surface 28 is performed by supplying the compressed air into the second cell 38 with operation of the air supply control valve 43B, then the suction pad P is further lifted from the table 24 to the lift height S2 and the wafer holder H is separated from the second cell 38 area in a inner direction. And then, as shown in Fig. 9, the compressed air is supplied into the third cell 39 by operation of air supply control valve 43C and the wafer holder H is furthermore lifted to a lift height S3 from the suction plane 28 of the table 24 sticking to the dicing tape T over the third cell 39 area, thus the whole of the wafer holder H is completely separated from the suction plane 28.

The wafer holder H completely separated from the suction plane 28 of the table 24 is then transferred to a dicer etc. of a next process for dicing process in which the wafer W is cut into dice.

Here, the lifting heights S1, S2 and S3 may be a height allowing a bowing deformation that does not induce stress such as a crack scratch to the wafer W, and are determined depending on the thickness of the wafer; thus they are not specifically limited.

Further, timings of initiating the supply of the compressed air to respective cells 37-39 may be altered from the outer side toward the inner side in order, as is described above, without altering the lifting height of the wafer holder H from the table 24.

Accordingly, the embodiments have such a configuration that the chamber 32 is divided into the first, second and third cells 37, 38 and 39 each isolated from others and, when the wafer holder H is removed from the table 24, air supply is started from the peripheral side from which air may escape easily according to the order of the first, second and third cells 37, 38 and 39 at predetermined timings to perform the vacuum break of a quasi-vacuum state between the dicing tape T of the wafer holder H and the suction plane 28 of the table 24 adhered by a residual pressure from the outer peripheral side of the table 24; thus the escapeway of the compressed air spurting from the suction holes 27 is secured gradually from the peripheral side of the wafer W toward the central side, obtaining the effect that the removal of wafer holder H from the table 24 can be achieved with almost no bowing deformation of the wafer W.

In the embodiment, the timings of initiating the air supply, at which flow rate or the like is generally the same one another, are staggered. However, the present invention is not limited to this, rather various supply means can be adopted as long as the wafer holder H can be removed from the table 24 without the occurrence of a substantial bowing deformation of the wafer W. For example, such adjustment may be acceptable that condition of supplied air such as flow volume or flow speed is altered from large to small from the first, second and third cells 37, 38 and 39 in order, while keeping the timings to supply the compressed air approximately the same.

The chamber 32 constituted of respective first, second and third cells 37-39 may also adopt any manners of division excluding the embodiment, as long as the same effect as described above can be achieved.

In addition, although the suction holding device 10 is applied to the peeling device 20 for peeling the protective sheet S from the wafer W, the present invention is not limited to this arrangement and may be used alone, or applied to other devices requiring to suck and hold an object such as a wafer or other thin plate materials.

As described above, according to the invention, since it is such arranged that a chamber is divided into a plurality of cells each isolated from others, and air is supplied independently, when an object is removed from a suction plane, into respective cells from an outer cell toward an inner cell in order and the object can be lifted, it is assured that a vacuum break takes place on the generally whole area between the object and suction plane sticking each other; thus a large bowing deformation of the object such as an ultrathin wafer can be prevented when the object is removed from the suction plane, and cracks of the ultrathin wafers can be prevented.

Further, since the chamber is divided from the peripheral side of the suction plane toward the central side thereof, the air supply can be independently controlled between the cells on the peripheral side of the object from which air is easy to escape and the central side of the object from which air is difficult to escape, thereby the bowing deformation of the object can be more securely prevented.

In addition, since the air supply is initiated from the cell located on the peripheral side of the suction plane toward the cell located on the central side thereof in order, the bowing deformation of the object can be effectively prevented.

## Claims

1. A suction holding device comprising a chamber in fluid communication with a suction plane, and being capable of sucking and holding a predetermined object on the suction plane, wherein:
said chamber is divided into a plurality of cells each isolated from others, and air is supplied independently to said respective cells when said object is removed from said suction plane; and
said air supply to said respective cells is initiated from a cell located on the peripheral side of said suction plane toward a cell located on the central side of said suction plane in order.

2. The suction holding device according to claim 1, wherein the chamber is divided from the peripheral side of said suction plane toward the central side.
